(19) Europäisches Patentamt
European Patent Office
Office européen des brevets

(11) EP 1 561 775 A2

(12) **EUROPÄISCHE PATENTANMELDUNG**

(43) Veröffentlichungstag:
**10.08.2005 Patentblatt 2005/32**

(21) Anmeldenummer: **05000975.2**

(22) Anmeldetag: **19.01.2005**

(51) Int Cl.7: **C08J 5/18**, C08J 7/04, C08J 7/18, B32B 27/36, C08L 67/00, B29C 47/00, B29D 7/01

(84) Benannte Vertragsstaaten:
**AT BE BG CH CY CZ DE DK EE ES FI FR GB GR HU IE IS IT LI LT LU MC NL PL PT RO SE SI SK TR**
Benannte Erstreckungsstaaten:
**AL BA HR LV MK YU**

(30) Priorität: **27.01.2004 DE 102004003890**

(71) Anmelder: **Mitsubishi Polyester Film GmbH**
**65203 Wiesbaden (DE)**

(72) Erfinder:
- **Kliesch, Holger, Dr.**
  **55252 Mainz (DE)**
- **Kiehne, Thorsten, Dr.**
  **24248 Mönkeberg (DE)**
- **Hilkert, Gottfried, Dr.**
  **55291 Saulheim (DE)**
- **Fischer, Ingo**
  **65558 Heistenbach (DE)**

(74) Vertreter: **Schweitzer, Klaus, Dr. et al**
**Patentanwaltskanzlei Zounek,**
**Industriepark Kalle-Albert,**
**Gebäude H391**
**Rheingaustrasse 190-196**
**65174 Wiesbaden (DE)**

(54) **Mittels elektromagnetischer Strahlung erhaltene ein- oder mehrschichtige, orientierte strukturierbare Folie aus thermoplastischem Polymer, Verfahren zu ihrer Herstellung und ihre Verwendung**

(57) Die Erfindung betrifft eine ein- oder mehrschichtige, orientierte Folie, bei der mindestens eine Schicht aus einem thermoplastischen Polymer mit einer Mindestmenge an Amidgruppen besteht. Das Polymer ist ein Polyester, ein Polyamid oder eine Mischung aus Polyester und Polyamid bzw. ein Copolymer aus beiden. Weiterhin enthält die Folie eine Komponente a), welche unter Bestrahlung mit elektromagnetischer oder partikulärer Strahlung Metallkeime bildet, an die sich in weiteren Prozessschritten weiteres Metall anlagern lässt. Die Erfindung betrifft ferner ein Verfahren zur Herstellung dieser Folie und ihre Verwendung in Leiterplatten, Flachbandkabeln, Smartcards, RFID-Labels, Folientastaturen und folienbasierten Schaltungen aller Art.

EP 1 561 775 A2

## Beschreibung

Die Erfindung betrifft eine ein- oder mehrschichtige, orientierte Folie, bei der mindestens eine Schicht aus einem thermoplastischen Polymer mit einer Mindestmenge an Amidgruppen besteht. Das Polymer ist ein Polyester, ein Polyamid oder eine Mischung aus Polyester und Polyamid beziehungsweise ein Copolymer aus beiden. Weiterhin enthält die Folie eine Komponente a), welche unter Bestrahlung mit elektromagnetischer oder partikulärer Strahlung Metallkeime bildet, an die sich in weiteren Prozessschritten weiteres Metall anlagern lässt. Die Erfindung betrifft ferner ein Verfahren zur Herstellung dieser Folie und ihre Verwendung in Leiterplatten, Flachbandkabeln, Smartcards, RFID-Labels, Folientastaturen und folienbasierten Schaltungen aller Art.

Die Verwendung von Polyesterfolien für Elektroisolieranwendungen ist Stand der Technik. Die immer höheren Anforderungen hinsichtlich Komplexität der Schaltungen auf kleinem Raum sowie die Notwendigkeit, solche Schaltungen schnell, flexibel und kostengünstig produzieren zu können, stellt hohe technologische Anforderungen an die Folie und die Weiterverarbeitungsschritte.

Konventionelle Verfahren zur Herstellung flexibler Schaltungen betreffen meist die vollflächige Metallisierung der Folienbahn oder Kaschierung der Folienbahn mit Metallfolie und anschließendes Strukturieren der so entstandenen leitfähigen Flächen mit verschiedenen Verfahren, z.B. Ätzen oder mechanisches Entfernen der unerwünschten Metallmengen. Bei weiteren Verfahren wird das Metall aufgeprägt/aufgedruckt, beziehungsweise wird eine Leitpaste aus Kohle/Silber aufgetragen. Nachteile dieser Verfahren liegen in der geringen Flexibilität und Präzision solcher Verfahren, welche einen größeren Abstand der Leiterbahnen untereinander bedingt und/oder der hohen mit diesen Verfahren verbundenen Kosten und/oder der niedrigen Produktionsgeschwindigkeiten.

In der EP-A-1 274 288 wird ein Verfahren beschrieben, bei dem aus kupferhaltigen Metalloxiden durch Laserbestrahlung Kupferkeime gebildet werden, an denen in einem anschließenden Galvanisierungsschritt weiteres Kupfer abgeschieden wird. In dieser Druckschrift werden ausschließlich Spritzgussteile beschrieben und es fehlen Hinweise wie und ob das Verfahren für Polyesterfolien und Folien im Allgemeinen angewendet werden kann. Insbesondere fehlen Hinweise, wie die Rohstoffe und Additive beschaffen sein müssen, um daraus orientierte Folien herstellen zu können. Das in EP-A-1 274 288 beschriebene PBT / $SiO_2$ / Spinell Compound ist zur Herstellung orientierter Folien ungeeignet, da das verwendete Polybutylenterephthalat aufgrund seiner hohen Kristallisationsgeschwindigkeit und dem hohen Füllgrad mit pyrogener Kieselsäure nicht verfahrenssicher verarbeitbar ist.

Insbesondere fehlen Hinweise wie eine Folie mit hinreichender Dimensionsstabilität bei lokaler Erwärmung nach Bestrahlung mit elektromagnetischer Strahlung und Weiterverarbeitung hergestellt werden kann.

Bei Folien besteht aufgrund der geringen Schichtdicke zudem das Problem, dass die Absorption von Strahlung zu gering ist und somit die absorbierte Energie unter Umständen zu gering sein kann, um die Umwandlung der Metallsalze in die elementaren Metalle auszulösen. Daher müssen die aktivierbaren Metallverbindungen in sehr hoher Konzentration zugegeben werden, was bei Schwermetallverbindungen wie Kupferverbindungen aufgrund von Umweltschutzaspekten nicht wünschenswert ist.

Besonders problematisch ist bei Folien zudem die leichte Biegbarkeit der Folienbahn. Dadurch unterliegt die Leiterbahn einem viel höheren mechanischen Stress als bei einem Spritzgussteil. Deshalb ist die Metallhaftung von großer Bedeutung. Im Stand der Technik sind Hinweise hierauf nicht gegeben.

Aufgabe der vorliegenden Erfindung ist es, eine Folie bereitzustellen, welche die genannten Nachteile nicht aufweist und die eine strahlungsaktivierbare Verbindung enthält, die Metallkeime bildet, an denen sich in weiteren Verfahrensschritten weiteres Metall anlagern lässt. Weiterhin soll eine solche Folie neben einer wirtschaftlichen Herstellung und einer guten Verstreckbarkeit, gute mechanische Eigenschaften, das bedeutet einen hohen E-Modul in Längs- und Querrichtung sowie einen definierten Schrumpf, aufweisen.

Gelöst wird diese Aufgabe durch eine ein- oder mehrschichtige, mindestens uniaxial gestreckte Folie mit einer Dicke von 5 bis 500 µm, bei der mindestens eine Schicht aus einem thermoplastischen Polymer mit einer Mindestmenge an Amidgruppen besteht, ferner enthält die Folie 0,5 bis 15 Gew.-% einer Komponente a), welche unter Bestrahlung mit elektromagnetischer oder partikulärer Strahlung Metallkeime bildet, an die sich in weiteren Prozessschritten weiteres Metall anlagern lässt.

Das thermoplastische Polymer ist ein Polyester, ein Polyamid oder eine Mischung aus Polyester und Polyamid beziehungsweise ein Copolymer aus beiden.

Die Folie besitzt eine Stärke vorzugsweise von 12 bis 200 µm und insbesondere von 30 bis 150 µm und enthält vorzugsweise 1,5 bis 10 Gew.-% und insbesondere 2 bis 8 Gew.-% der Komponente a).

Unter der strahlungsaktivierbaren Verbindung a) ist eine metallhaltige (anorganische oder organische) Verbindung zu verstehen, die infolge einer Absorption von elektromagnetischer Strahlung in einer chemischen Reaktion Metall in elementarer Form freisetzt. Diese chemische Reaktion kann auch unter Beteiligung weiterer Reaktionspartner erfolgen. Weiterhin ist es möglich, dass die elektromagnetische Strahlung nicht direkt von der metallhaltigen Verbindung absorbiert wird, sondern durch andere Substanzen, die anschließend die absorbierte Energie auf die metallhaltige Verbindung übertragen und so die Freisetzung von elementarem Metall bewirken. Bei der elektromagnetischen Strahlung kann es sich um UV-Licht (Wellenlänge 100 bis 400 nm), sichtbares Licht (Wellenlänge 400 bis 800 nm) oder Infrarotlicht (Wellenlänge 800 bis 25000 nm) handeln. Weitere bevorzugte Strahlungsformen sind Röntgen-, Gamma- und Partikelstrahlung (Elektronen-, $\alpha$- und $\beta$-Strahlung).

Die Anlagerung von weiterem Metall an die durch elektromagnetische Strahlung erzeugten Metallkeime erfolgt bevorzugt durch galvanische (nasschemische) Verfahren.

Zu einer guten Verstreckbarkeit zählt, dass sich die Folie bei ihrer Herstellung hervorragend uniaxial oder biaxial ohne Abrisse orientieren lässt.

Zu den guten mechanischen Eigenschaften zählen unter anderem ein hoher E-Modul in mindestens einer Folienrichtung (Längsrichtung (MD) und/oder Querrichtung (TD)) von $\geq$ 500 N/mm$^2$, bevorzugt $\geq$ 2000 N/mm$^2$ und besonders bevorzugt $\geq$ 4000 N/mm$^2$.

In einer bevorzugten Ausführungsform weist die Folie gemäß der Erfindung in keiner Folienrichtung (weder in MD noch in TD) einen Schrumpf von > 25 % bei 200 °C auf. Vorzugsweise ist der Schrumpf bei 200 °C $\leq$ 15 %, insbesondere $\leq$ 5 %.

Die erfindungsgemäße Folie enthält als Hauptpolymerbestandteil bezogen auf jede Schicht (d.h. zu 55 bis 100 Gew.-%, bevorzugt 70 bis 100 Gew.-% und besonders bevorzugt 90 bis 100 Gew.-%) einen Polyester oder ein Polyamid.

Die Schicht, welche die strahlungsaktivierbare Komponente a) enthält, enthält mindestens 1 Gew.-% Polyamid, bevorzugt mindestens 3 Gew.-% und besonders bevorzugt mindestens 10 Gew.-% Polyamid.

Erfindungsgemäß versteht man unter einem Polyester

- Homopolyester,
- Copolyester,
- Blends verschiedener Polyester,

wobei diese sowohl als reine Rohstoffe, als auch als Rezyklat enthaltende Polyesterrohstoffe eingesetzt werden können.

Polyester enthalten Wiederholungseinheiten, die sich von Dicarbonsäuren (100 Mol-%) und Diolen (ebenfalls 100 Mol-%) ableiten. Die erfindungsgemäßen Polyester basieren bevorzugt auf Terephthalsäure oder 2,6-Naphthalindicarbonsäure als Dicarbonsäure und auf Ethylenglykol oder 1,4-Butandiol als Diol (PET, PBT und PEN).

Insbesondere enthalten die erfindungsgemäßen Polyester 10 bis 100 Mol-% Terephthalat oder 10 bis 100 Mol-% 2,6-Naphthalat als Dicarbonsäurekomponenten (wobei die Gesamtmenge an Dicarbonsäurekomponenten 100 Mol-% ausmacht). Als weitere Dicarbonsäurekomponenten kann der erfindungsgemäße Polyester 0 bis 50 Mol-% 2,6-Naphthalat (wenn als Hauptkomponente Terephthalat eingesetzt wurde), 0 bis 50 Mol-% Terephthalat (wenn als Hauptkomponente Naphthalat verwendet wurde), 0 bis 20 Mol-% Isophthalat (bevorzugt 0,5 bis 4 Mol-%) sowie 10 bis 60 Mol-% 4,4'-Diphenyldicarboxylat enthalten. Andere Dicarbonsäurekomponenten wie 1,5-Naphthalindicarboxylat sollen gegebenenfalls einen Anteil von 30 Mol-%, bevorzugt 10 Mol-%, insbesondere 2 Mol-%, nicht überschreiten.

Als Diolkomponente enthält der erfindungsgemäße Polyester im Allgemeinen 10 bis 100 Mol-% Ethylenglykol (EG) (wobei die Gesamtmenge an Diolkomponenten 100 Mol-% ausmacht). Werden Mischungen verschiedener Diole eingesetzt, ist es vorteilhaft, den Anteil an Diethylenglykol mit 10 Mol-% nicht zu überschreiten und vorzugsweise 0,5 bis 5 Mol-% einzusetzen. Andere Diolkomponenten wie Cyclohexandimethanol, 1,3-Propandiol, 1,4-Butandiol sollen zweckmäßigerweise einen Anteil von 50 Mol-% nicht überschreiten und liegen bevorzugt bei einem Anteil von weniger als 30 Mol-%, besonders bevorzugt bei weniger als 10 Mol-%.

Die angeführten Polyester können auch als Mischungen eingesetzt werden.

Erfindungsgemäß versteht man unter einem Polyamid

- Homopolyamide,
- Co-Polyamide,
- Blends verschiedener Polyamide,

wobei diese sowohl als reine Rohstoffe, als auch als Rezyklat enthaltende Polyamidrohstoffe eingesetzt werden können.

Die Polyamide sind bevorzugt teilkristalline Polyamide wie Nylon 6, Nylon 6/6, Nylon 6/12, MXD6 oder Blends derselben. Neben diesen teilkristallinen Polyamiden sind amorphe Polyamide wie Hexamethylenisophthalamid-hexamethylen-terephthalamid -Copolymer auch bekannt als Nylon 6I/6T oder dessen Blends mit Hexamethylenisophthalamid bevorzugt (z.B. "Selar® PA" von DuPont oder "Grivory®" von EMS Chemie). Die genannten Polyamide können ganz oder teilweise durch andere Polyamide ersetzt werden.

Neben den genannten Hauptpolymerbestandteilen kann die Folie in weiteren Ausführungsformen bis zu 45 Gew.-%, bevorzugt bis zu 30 Gew.-%, besonders bevorzugt bis zu 20 Gew.-%, bezogen auf die Masse der Folie,

andere Polymere wie Polyetherimide (z.B. Ultem® 1000 von GE Plastics Europe/NL), Polycarbonat (z.B. Makrolon® von Bayer/DE), Polyolefine wie COC's (z.B. Topas® von Ticona/DE), Polyamide (Ultramid® von BASF/ DE) u.a. enthalten.

Allgemein werden die Polyester und die Polyamide nach literaturbekannten Verfahren hergestellt. Die Herstellung der Polyester kann sowohl nach dem Umesterungsverfahren mit den üblichen Katalysatoren wie Zn-, Ca-, Li- und Mn-Salzen oder nach dem Direktveresterungsverfahren erfolgen.

Die erfindungsgemäße Folie ist entweder ein- oder mehrschichtig. Die mehrschichtigen Folien sind mindestens zweischichtig und bestehen aus einer Basisschicht B, mindestens einer Deckschicht A oder C und gegebenenfalls weiteren Zwischenschichten, wobei insbesondere ein dreischichtiger A-B-A- oder A-B-C-Aufbau bevorzugt ist. Für diese Ausführungsform ist es vorteilhaft, wenn das Polymer der Basisschicht B eine ähnliche Schmelzeviskosität besitzt wie jene(s) der Deckschicht(en), die an die Basisschicht angrenzt (angrenzen).

Die Dicke der Deckschicht/en wird unabhängig von den anderen Schichten gewählt und liegt im Bereich von 0,1 bis 10 µm, vorzugsweise 0,2 bis 5 µm, insbesondere 1 bis 3 µm,
wobei beidseitig aufgebrachte Deckschichten bezüglich Dicke und Zusammensetzung gleich oder verschieden sein können. Die Dicke der Basisschicht ergibt sich entsprechend aus der Differenz von Gesamtdicke der Folie und der Dicke der aufgebrachten Deck- und Zwischenschicht/en und kann daher analog der Gesamtdicke innerhalb weiter Grenzen variieren.

Bei einer bevorzugten Ausführungsform enthält die Folie bei einschichtigen Folien 1 bis 35 Gew.-% Polyamid, bevorzugt 3 bis 20 Gew.-% und besonders bevorzugt 10 bis 15 Gew.-% Polyamid. Bei mehrschichtigen Aufbauten enthält die Schicht, welche die strahlungsaktivierbare Komponente a) enthält, 1 bis 35 Gew.-% Polyamid, bevorzugt 3 bis 20 Gew.-% und besonders bevorzugt 10 bis 15 Gew.-% Polyamid. Die übrigen Schichten bestehen bevorzugt aus den oben beschriebenen Polyestern und enthalten 0 bis 15 Gew.-% Polyamid, bevorzugt 0,5 bis 5 Gew.-% Polyamid.

Wenn Zusammensetzungen gewählt werden, die überwiegend aus Polyamid bestehen (mehr als 50 Gew.-%), so enthält/enthalten diese Schicht/Schichten bevorzugt weniger als 20 Gew.-% Polyester und besonders bevorzugt weniger als 5 Gew.-% Polyester.

Die strahlungsaktivierbare Verbindung a) besteht aus elektrisch nichtleitenden, thermisch hochstabilen organischen oder anorganischen Metallverbindungen, die bevorzugt in wässrigen sauren oder alkalischen Metallisierungsbädern beständig und nicht löslich sind. Besonders geeignet sind solche Verbindungen, die Licht der eingestrahlten Wellenlänge möglichst vollständig absorbieren. Solche Verbindungen sind in EP-A-1 274 288 beschrieben. Bevorzugt sind hierbei Verbindungen von Metallen der d- und f- Gruppe des Periodischen Systems mit Nichtmetallen. Besonders bevorzugt handelt es sich bei den metallhaltigen Verbindungen um Metalloxide, insbesondere um Monoxide derd-Metalle des Periodischen Systems. Besonders geeignet sind höhere Metalloxide. Gemäß einer besonders bevorzugten Ausführungsform der Erfindung sind die höheren Oxide Spinelle, insbesondere kupferhaltige Spinelle wie $CuCr_2O_4$. Geeignete kupferhaltige Spinelle sind kommerziell erhältlich, so z.B. der Typ PK 3095 der Fa. Ferro/DE oder die Typen 34E23 oder 34E30 der Fa. Johnson Matthey/DE. Besonders geeignet sind weiterhin Kupferoxide der Formel CuO oder $Cu_2O$, wobei bevorzugt Nanopartikel eingesetzt werden wie NanoArc® Copper Oxide von der Fa. Nanophase Technologies Corporation/Illinois, USA.

Die erfindungsgemäße Folie enthält diese Verbindungen in einer Konzentration von 0,5 bis 15 Gew.-%, bevorzugt 1,5 bis 10 Gew.-% und besonders bevorzugt 2 bis 8 Gew.-%.

Sofern die metallhaltige Verbindung a) in dem zur Folienherstellung verwendeten Polyester nicht löslich ist, handelt es sich um Partikel mit einer mittleren Größe ($d_{50}$-Wert) von 0,01 bis 20 µm, bevorzugt 0,02 bis 5 µm und besonders bevorzugt 0,05 bis 3 µm.

Neben der strahlungsaktivierbaren Verbindung a) kann die erfindungsgemäße Folie weitere partikuläre Additive wie Füllstoffe und Antiblockmittel enthalten. Typische Füllstoffe und Antiblockmittel sind anorganische und/oder organische Partikel, beispielsweise Siliciumdioxid (natürlich, gefällt oder pyrogen), Calciumcarbonat, Magnesiumcarbonat, Bariumcarbonat, Calciumsulfat, Bariumsulfat, Lithiumphosphat, Calciumphosphat, Magnesiumphosphat, Titandioxid (Rutil oder Anatas), Kaolin (hydratisiert oder kalziniert), Aluminiumoxid, Aluminiumsilikate, Lithiumfluorid, Calcium-, Barium-, Zink- oder Mangansalze der eingesetzten Dicarbonsäuren oder vernetzte Polymerpartikel, z.B. Polystyrol oder Polymethylmethacrylatpartikel.

Es können auch Mischungen von zwei oder mehreren der oben genannten Partikelsysteme oder Mischungen von Partikelsystemen mit gleicher chemischer Zusammensetzung, aber unterschiedlicher Partikelgröße gewählt werden. Die Partikel werden dem Polymer zweckmäßigerweise schon vor dem Aufschmelzen zugesetzt.

Sofern neben der strahlungsaktivierbaren Verbindung a) weitere partikuläre Additive in der Folie enthalten sind, beträgt die Gesamtkonzentration dieser Partikel $\leq$ 20 Gew.-%, bezogen auf das Gesamtgewicht der Folie, bevorzugt $\leq$ 15 Gew.-% und besonders bevorzugt $\leq$ 5 Gew.-%. Die partikulären Additive haben eine mittlere Größe ($d_{50}$-Wert) von 0,01 bis 15 µm, bevorzugt 0,03 bis 10 µm und besonders bevorzugt 0,05 bis 1 µm. In einer bevorzugten Ausführungsform liegt der Anteil von Partikeln mit einem $d_{50}$-Wert von $\geq$ 3 µm bei $\leq$ 2000 ppm und besonders bevorzugt

bei ≤ 1000 ppm.

Es hat sich gezeigt, dass auch Folien ohne weitere partikuläre Additive (außer der strahlungsaktivierbaren Metallkomponente a)) gemäß der Erfindung eingesetzt werden können. Die Bildung der Metallkeime wird jedoch verbessert, wenn die Folie als Füllstoff Siliziumdioxid in den oben genannten Maximalmengen und Teilchengrößen enthält. Fürdie Bildung der Metallkeime hat es sich als besonders günstig erwiesen, wenn die Folie 0,1 bis 20 Gew.-% bevorzugt 0,5 bis 15 Gew.-% und besonders bevorzugt 1 bis 5 Gew.-% Siliciumdioxid-Partikel mit einem $d_{50}$-Wert von ≤ 1 µm enthält.

Alternativ zum $SiO_2$ kann auch $Al_2O_3$ (z.B. AEROXIDE® Alu C der Fa. Degussa/DE) eingesetzt werden. Die Mengen und Partikelgrößen entsprechen denen, die im vorhergehenden Absatz für $SiO_2$ genannt wurden.

Die erfindungsgemäße Folie enthält gegebenenfalls in einer bevorzugten Ausführungsform neben der strahlungsaktivierbaren Metallverbindung a) ein weiteres, Strahlung absorbierendes Material b) in einer Menge von 0,1 bis 15 Gew.-%, bevorzugt 0,5 bis 5 Gew.-% und besonders bevorzugt 0,8 bis 2 Gew.-%, bezogen auf die Folie. Dieses Material absorbiert bevorzugt im Wellenlängenbereich der zur Metallkeimbildung verwendeten Strahlenquelle.

Bevorzugte Materialien sind dabei Graphit oder Ruß oder anorganische und organische Schwarzpigmente wie Pigment Black26 (z.B. $Fe_2O_3/MnO_2/SiO_2/Al_2O_3$ der Fa. Anirox Pigments Limited / IN) oder Anilinschwarz der Fa. Degussa/DE. Bei Rußen und Graphiten ist es vorteilhaft, Typen mit geringer Leitfähigkeit wie Spezialschwarz4 oder Aerospace15 der Fa. Degussa / DE zu verwenden.

Die erfindungsgemäße Folie kann weitere Additive wie UV-Stabilisatoren, Flammschutzmittel, Hydrolysestabilisatoren und Antioxidantien enthalten, wobei insbesondere UV-Stabilisatoren wie Tinuvin® der Fa. Ciba/CH ebenfalls zu einer verbesserten Metallkeimbildung beitragen, wenn eine UV-Strahlenquelle verwendet wird, da sie die eingestrahlte UV-Energie effektiv absorbieren.

In einer weiteren Ausführungsform ist die erfindungsgemäße Folie flammhemmend ausgerüstet. Flammhemmend bedeutet, dass die Folie in einer sogenannten Brandschutzprüfung gemäß UL94 VTM mindestens die Klasse VTM-2 erreichen. Die Folie enthält dann ein Flammschutzmittel in einer Konzentration im Bereich von 0,2 bis 30 Gew.-%, bevorzugt 0,5 bis 25 Gew.-%, besonders bevorzugt von 1 bis 20 Gew.-%, bezogen auf das Gewicht der Folie. Wesentlich ist, dass das Flammschutzmittel im Polyester löslich ist, da andernfalls die geforderten mechanischen Eigenschaften nicht erreicht werden. Geeignete Flammschutzmittel sind beispielsweise organische Brom-, Chlor- oder Stickstoffverbindungen oder Metallhydroxide oder -trihydrate. Die Halogenverbindungen haben allerdings den Nachteil, dass im Brandfall toxische und korrosiv wirkende Halogenwasserstoffe entstehen. Nachteilig ist auch die geringe Lichtbeständigkeit einer damit ausgerüsteten Folie. Weitere geeignete Flammschutzmittel sind beispielsweise organische Phosphorverbindungen wie Carboxyphosphinsäuren, deren Anhydride und Methanphosphonsäuredimethylester. Sehr geeignet sind hierbei Flammschutzmittel, bei denen die Phosphorverbindung chemisch an den Polyester gebunden ist. Ganz besonders bevorzugt ist [(6-oxido-6H-dibenz[c,e][1,2]oxaphosphorin-6-yl)methyl]butandicarbonsäure-bis-(2-hydroxy ethyl)ester mit der Formel

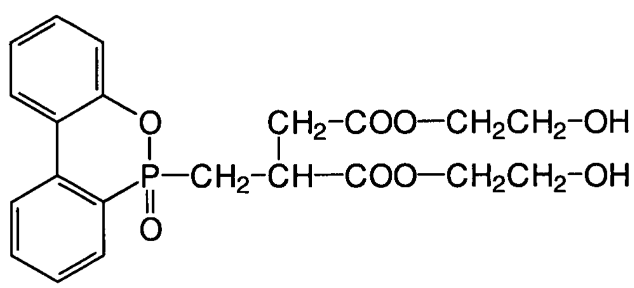

In dieser bevorzugten Ausführungsform enthält die erfindungsgemäße, schwer entflammbare Folie neben dem Polymer, der strahlungsaktivierbaren Verbindung und gegebenenfalls partikulären Additiven, 1 bis 20 Gew.-% einer im Polymer löslichen organischen Phosphorverbindung als Flammschutzmittel.

Da die Flammschutzmittel im allgemeinen eine gewisse Hydrolyseempfindlichkeit aufweisen, kann der zusätzliche Einsatz eines Hydrolysestabilisators sinnvoll sein. Geeignete Hydrolysestabilisatoren sind beispielsweise polymere Carbodiimide wie z.B. Stabaxol® P der Fa. Rheinchemie/DE. Diese werden bevorzugt in einer Menge von 0,1 bis 1 Gew.-%, bezogen auf die Masse der Folie, eingesetzt.

Diese oben genannten Anteile an Flammschutzmittel und Hydrolysestabilisator haben sich auch dann als günstig erwiesen, wenn der Hauptbestandteil der Folie nicht Polyethylenterephthalat, sondern ein anderer Polyester oder Polyamid ist.

Die strahlungsaktivierbare Verbindung a) sowie gegebenenfalls die Strahlung absorbierende Verbindung b)

und die weiteren verwendeten Additive wie Partikel, UV-Stabilisatoren, Flammschutzmittel, Hydrolysestabilisatoren und Antioxidantien können dem zur Herstellung der erfindungsgemäßen Folie verwendeten Polyester als glykolische Dispersion während der Polykondensation zugegeben werden. Bevorzugt ist jedoch die Zugabe der strahlungsaktivierbaren Komponente und/oder der gegebenenfalls verwendeten weiteren Additive über Masterbatche zum Polymerrohstoff während der Folienextrusion.

Ebenso kann die Folie zur Einstellung weiterer Eigenschaften beschichtet werden. Typische Beschichtungen sind insbesondere haftvermittelnd, antistatisch, schlupfverbessernd oder dehäsiv wirkende Schichten. Es bietet sich an, diese zusätzlichen Schichten über in-line coating mittels wässriger Dispersionen nach der Längs- und vor der Querstreckung auf die Folie aufzubringen.

In einer besonderen Ausführungsform weist die Folie mindestens einseitig eine Silikonbeschichtung auf, wie sie z.B. in der US-A-5728339 beschrieben ist. Diese Ausführungsform hat den Vorteil, dass nach der Laserbehandlung die umliegenden Bereiche vor der korrodierenden Wirkung des galvanischen Bades geschützt sind und sich Reste der Galvaniklösung leichter von der Folienoberfläche entfernen lassen.

Für bestimmte Anwendungen kann es zweckmäßig sein, die Oberfläche der Folie mit einer Säure chemisch vorzubehandeln. Für diese sogenannte Ätzhaftvermittlung eignen sich insbesondere Trichloressigsäure, Dichloressigsäure oder Flusssäure, die für eine kurze Zeit (zwischen 5 und 120 sec) auf die Oberfläche einwirken und dann mittels Luftmesser wieder entfernt werden. Dadurch erhält die Folie eine sehr reaktive, amorphe Oberfläche.

Die Additive, also die strahlungsaktivierbare Metallverbindung a) sowie die gegebenenfalls vorhandenen weiteren Verbindungen, Füllstoffe und sonstigen Additive, können mittels eines handelsüblichen Zweischneckenextruders in das Polymer eingebracht werden. Dabei wird ein Polymer gemäß der Erfindung in Granulatform zusammen mit den Partikeln/Additiven in den Extruder eingebracht und extrudiert, anschließend in einem Wasserbad abgeschreckt und dann granuliert.

In einem bevorzugten Verfahren zur Herstellung der erfindungsgemäßen Polyester/Polyamide werden die Additive aber direkt bei der Polymerherstellung zugegeben.

Bei der Herstellung der erfindungsgemäßen Polyester werden die Additive im Falle des DMT-Verfahrens üblicherweise nach der Umesterung bzw. direkt vor der Polykondensation (z.B. über die Transportleitung zwischen Umesterungs- und Polykondensationskessel) als glykolische Dispersion zugegeben. Die Zugabe kann aber auch schon vor der Umesterung erfolgen. Im Falle des TPA-Verfahrens erfolgt die Zugabe bevorzugt zu Beginn der Polykondensation. Eine spätere Zugabe ist jedoch auch möglich. Es hat sich bei diesem Verfahren als günstig erwiesen, wenn die glykolischen Dispersionen vor der Zugabe über einen PROGAF PGF 57 (Hayward Ind./US) Filter filtriert werden.

Gegenstand der vorliegenden Erfindung ist auch ein Verfahren zur Herstellung der Folie. Allgemein erfolgt die Herstellung durch ein Extrusionsverfahren, beispielsweise auf einer Extrusionsstrasse. Als besonders vorteilhaft hat es sich erwiesen, die strahlungsaktivierbare Komponente a) und die gegebenenfalls verwendeten weiteren Additive, wie die Komponente b), Partikel, UV-Stabilisatoren, Flammschutzmittel, Hydrolysestabilisatoren und Antioxidantien, in den genannten Mengen in Form von vorgetrockneten oder vorkristallisierten Masterbatchen vor der Extrusion zuzugeben.

Bevorzugt bei der Masterbatchtechnologie ist, dass die Korngröße und das Schüttgewicht der Masterbatche ähnlich der Korngröße und dem Schüttgewicht des verwendeten Polyesterrohstoffs ist, so dass eine homogene Verteilung erreicht wird, aus der homogene Eigenschaften resultieren.

Die Polyester-/Polyamidfolien können nach bekannten Verfahren aus einem Polymerrohstoff und gegebenenfalls weiteren Rohstoffen, mindestens einer strahlungsaktivierbaren Komponente sowie gegebenenfalls weiteren Additiven als ein- oder mehrschichtige Folie hergestellt werden.

Masterbatche, die die strahlungsaktivierbare Komponente enthalten, sind bevorzugt vorkristallisiert und/oder vorgetrocknet. Das gleiche gilt für Masterbatche, die die Strahlung absorbierende Komponente oder Partikel, UV-Stabilisator(en), Flammschutzmittel und/oder andere Additive enthalten. Die Vortrocknung beinhaltet ein graduelles Erhitzen der Masterbatche unter reduziertem Druck (20 bis 80 mbar, vorzugsweise 30 bis 60 mbar, insbesondere 40 bis 50 mbar) sowie Rühren und gegebenenfalls ein Nachtrocknen bei konstanter, erhöhter Temperatur (ebenfalls unter reduziertem Druck). Die Masterbatche werden vorzugsweise bei Raumtemperatur aus einem Dosierbehälter in der gewünschten Abmischung zusammen mit dem Polyesterrohstoff und gegebenenfalls anderen Rohstoffkomponenten chargenweise in einen Vakuumtrockner, der im Laufe der Trocken- bzw. Verweilzeit ein Temperaturspektrum von 10 bis 160 °C, vorzugsweise 20 bis 150 °C, insbesondere 30 bis 130 °C durchläuft, gefüllt. Während der etwa 6-stündigen, vorzugsweise 5-stündigen, insbesondere 4-stündigen, Verweilzeit wird die Rohstoffmischung mit 10 bis 70 Upm, vorzugsweise 15 bis 65 Upm, insbesondere 20 bis 60 Upm, gerührt. Das so vorkristallisierte bzw. vorgetrocknete Rohstoffgemisch wird in einem nachgeschalteten ebenfalls evakuierten Behälter bei 90 bis 180 °C, vorzugsweise 100 bis 170 °C, insbesondere 110 bis 160 °C, für 2 bis 8 Stunden, vorzugsweise 3 bis 7 Stunden, insbesondere 4 bis 6 Stunden, nachgetrocknet.

Die Masterbatche sowie die übrigen Rohstoffe können aber auch bei Verwendung von Zwei- und Mehrschnek-

kenextrudern ohne Vortrocknung direkt extrudiert werden.

Bei dem bevorzugten Koextrusionsverfahren zur Herstellung der Folie werden die den einzelnen Schichten der Folie entsprechenden Schmelzen durch eine Flachdüse koextrudiert und als weitgehend amorphe Vorfolie auf einer Kühlwalze abgeschreckt (bei der erfindungsgemäßen einschichtigen Folie wird nur eine Schmelze durch die Düse extrudiert). Diese Folie wird anschließend erneut erhitzt und in mindestens einer Richtung bzw. in Längs- und Querrichtung bzw. in Quer- und Längsrichtung bzw. in Längs-, in Querund nochmals und Längsrichtung und / oder Querrichtung verstreckt (orientiert). Die Folientemperaturen im Streckprozess liegen im allgemeinen 10 bis 60 °C über der höchsten Glasübergangstemperatur $T_g$ des verwendeten Polyesters/Polyamidrohstoffs, das Streckverhältnis der Längsstreckung liegt üblicherweise bei 2 bis 6, insbesondere bei 3 bis 4,5, das der Querstreckung bei 2 bis 5, insbesondere bei 3 bis 4,5, und das der gegebenenfalls durchgeführten zweiten Längs- und Querstreckung bei 1,1 bis 5. Die erste Längsstreckung kann auch gleichzeitig mit der Querstreckung (Simultanstreckung) durchgeführt werden. Es folgt die Thermofixierung der Folie bei Ofentemperaturen von 180 bis 260 °C, vorzugsweise von 220 bis 250 °C. Anschließend wird die Folie abgekühlt und gewickelt.

In einer bevorzugten Ausführungsform findet die Thermofixierung bei Temperaturen von 220 bis 250 °C statt und die Folie wird bei dieser Temperatur um mindestens 1 %, bevorzugt mindestens 2 %, in Querrichtung relaxiert.

In einer weiteren bevorzugten Ausführungsform findet die Thermofixierung bei Temperaturen von 220 bis 250 °C statt und die Folie wird bei dieser Temperatur um mindestens 1 %, bevorzugt mindestens 2 %, in Querrichtung relaxiert und anschließend nochmals bei Temperaturen zwischen 180 und 150 °C in der Abkühlphase um wiederum mindestens 1 %, bevorzugt mindestens 2 %, in Querrichtung relaxiert.

In einer weiteren bevorzugten Ausführungsform wird die Folie mindestens um den Faktor 3 in MD und TD Richtung gestreckt, wobei die Streckung in einem Simultanrahmen stattfindet. Die Thermofixierung findet bei Temperaturen von 220 bis 250 °C statt und die Folie wird bei dieser Temperatur um mindestens 1 % in Längs- und Querrichtung relaxiert.

Die erfindungsgemäßen ein- oder mehrschichtigen Folien weisen die geforderten guten mechanischen Eigenschaften auf. So beträgt der E-Modul in mindestens einer Folienrichtung (Längsrichtung (MD) und/oder Querrichtung (TD)) ≥ 500 N/mm$^2$, bevorzugt ≥ 2000 N/mm$^2$ und besonders bevorzugt ≥ 4000 N/mm$^2$.

Durch die Kombination ihrer Eigenschaften eignen sich die erfindungsgemäßen Folien für eine Vielzahl verschiedener Anwendungen, beispielsweise für Leiterplatten, Flachbandkabel, Smartcards, RFID-Labels, Folientastaturen und folienbasierte Schaltungen aller Art.

Die Messung der einzelnen Eigenschaften in den Beispielen erfolgt gemäß den folgenden Normen bzw. Verfahren.

**Messmethoden**

**Mechanische Eigenschaften**

Der E-Modul, die Reißfestigkeit, Reißdehnung und der $F_5$-Wert werden in Längs- und Querrichtung nach ISO 527-1-2 mit Hilfe eines Zug-Dehnungsmessgeräts (Fa. Zwick/DE, Typ 010) gemessen.

**Schrumpf**

Der thermische Schrumpf wird an quadratischen Folienmustern mit einer Kantenlänge von 10 cm bestimmt. Die Proben werden genau ausgemessen (Kantenlänge $L_0$), 15 Minuten bei 200 °C in einem Umlufttrockenschrank getempert und anschließend bei Raumtemperatur genau ausgemessen (Kantenlänge L). Der Schrumpf ergibt sich aus der Gleichung

$$\text{Schrumpf [\%]} = 100 \cdot (L_0 - L) / L_0$$

**Messung des mittleren Durchmessers $d_{50}$**

Die Bestimmung des mittleren Durchmessers $d_{50}$ wird mittels Laser auf einem Malvern Master Sizer nach der Standardmethode durchgeführt. Andere Messgeräte sind z.B. Horiba LA 500 oder Sympathec Helos, welche das gleiche Messprinzip verwenden. Die Proben werden dazu in eine Küvette mit Wasser gegeben und diese dann in das Messgerät gestellt. Der Messvorgang ist automatisch und beinhaltet auch die mathematische Bestimmung des $d_{50}$-Wertes.

Der $d_{50}$-Wert wird dabei definitionsgemäß aus der (relativen) Summenkurve der Partikelgrößenverteilung bestimmt: der Schnittpunkt des 50 %-Ordinatenwertes mit der Summenkurve liefert auf der Abszissenachse sofort den

gewünschten $d_{50}$-Wert. Wie dies zu verstehen ist, wird in Figur 1 näher verdeutlicht.

**Folienherstellung**

Polymer-Chips wurden gemäß den in den Beispielen angegebenen Verhältnissen gemischt und ohne Vortrocknung jeweils in Zweischneckenextrudern aufgeschmolzen. Die geschmolzenen Polymerstränge wurden in einer Koextrusionsdüse zusammengeführt und über eine Abzugswalze (Temperatur der Walze 20 °C) abgezogen. Der Film wurde um den Faktor 3,5 in Maschinenrichtung bei 116 °C (Folientemperatur im Streckspalt) gestreckt und in einem Rahmen bei 110 °C eine Querstreckung um den Faktor 3,2 durchgeführt. Anschließend wurde die Folie bei 229 °C thermofixiert und in Querrichtung um 1 % bei Temperaturen von 229 bis 200 °C und ein weiteres mal um 1 % bei Temperaturen zwischen 180 und 150 °C relaxiert. Die Produktionsgeschwindigkeit (Endfoliengeschwindigkeit) betrug 300 m/min. Endfoliendicke 100 µm.

**Beispiele**

In den Beispielen kommen die folgenden Rohstoffe zum Einsatz.

**Masterbatch MB1**

15 Gew.-% PK3095 der Fa. Ferro und 85 Gew.-% Polyethylenterephthalat RT49 (PET) der Fa. Kosa/DE

**Masterbatch MB2**

10 Gew.-% $Al_2O_3$ AEROXIDE® Alu C der Fa. Degussa/DE ($d_{50}$ der Agglomerate ca. 300 nm; Primärteilchen $d_{50}$ ca. 50 nm) und 90 Gew.-% Polyethylenterephthalat RT49 (PET)

**Masterbatch MB3**

15 Gew.-% CuO Nanopartikel NanoArc® Copper Oxide der Fa. Nanophase Technologies Corporation/Illinois, USA und 85 Gew.-% Polyethylenterephthalat RT49 (PET)

**Masterbatch MB4**

15 Gew.-% Pigment Black26 ($Fe_2O_3/MnO_2/SiO_2/Al_2O_3$) der Fa. Anirox Pigments Limited /IN und 85 Gew.-% Polyethylenterephthalat RT49 (PET)

**Masterbatch MB5**

15 Gew.-% Spezialschwarz4 der Fa. Degussa/DE und 85 Gew.-% Polyethylenterephthalat (PET)

**Rohstoff R1**

100 Gew.-% Polyethylenterephthalat RT49

**Rohstoff R2**

25 Gew.-% Aerosil 90 der Fa. Degussa/DE, 5 Gew.-% PK3095 der Fa. Ferro und 70 Gew.-% Polybutylenterephthalat (PBT)

**Rohstoff R3**

100 Gew.-% Poly(m-xylol-adipinamid) (MXD6) der Fa. Mitsubishi Gas Chemical Co., Produktname Nylon MXD6 6001 mit einer Schmelzviskosität von 1400 Poise

**Rohstoff R4**

100 Gew.-% Amorphes Polyamid Grivory G 21 von Ems Chemie/CH

**Beispiel 1**

Es wurde eine ABC-Folie mit einer Dicke der Basisschicht von 94 µm und Deckschichten A und C mit je 3 µm, wie oben angegeben, hergestellt.
Rohstoffmischung Deckschicht A: 50 Gew.-% MB1; 10 Gew.-% MB2; 10 Gew.-% MB4; 20 Gew.-% R1; 10 Gew.-% R3
Rohstoffmischung Basisschicht B: 100 Gew.-% R1
Rohstoffmischung Deckschicht C: 20 Gew.-% MB2; 80 Gew.-% R1

**Beispiel 2**

Es wurde eine ABC-Folie mit einer Dicke der Basisschicht von 94 µm und Deckschichten A und C mit je 3 µm, wie oben angegeben, hergestellt.
Rohstoffmischung Deckschicht A: 60 Gew.-% MB3; 10 Gew.-% MB2; 10 Gew.-% MB5; 12 Gew.-% R1; 8 Gew.-% R4
Rohstoffmischung Basisschicht B: 100 Gew.-% R1
Rohstoffmischung Deckschicht C: 20 Gew.-% MB2; 80 Gew.-% R1

**Beispiel 3**

Es wurde eine ABC-Folie mit den gleichen Dimensionen wie in Beispiel 1 hergestellt.
Rohstoffmischung Deckschicht A: 60 Gew.-% MB3; 10 Gew.-% MB2; 12 Gew.-% R1; 18 Gew.-% R4
Rohstoffmischung Basisschicht B: 100 Gew.-% R1
Rohstoffmischung Deckschicht C: 20 Gew.-% MB2; 80 Gew.-% R1

**Beispiel 4**

Es wurde eine Folie mit den gleichen Dimensionen wie in Beispiel 1 hergestellt.
Rohstoffmischung Deckschicht A = Basisschicht B und Deckschicht C: 50 Gew.-% MB3; 10 Gew.-% MB2; 10 Gew.-% MB5; 22 Gew.-% R1; 8 Gew.-% R4

**Vergleichsbeispiel 1**

Es wurde versucht, wie oben angegeben, aus dem Rohstoff R2 (angelehnt an den Rohstoff aus dem Beispiel der EP-A-1 274 288) eine ABA-Folie mit einer Dicke der Basisschicht von 46 µm und Deckschichten A mit je 2 µm herzustellen.
Rohstoffmischung Deckschicht A: 100 Gew.-% R2
Rohstoffmischung Basisschicht B: 100 Gew.-% R2
Die Verstreckung der Folie erwies sich als unmöglich, da jeder Streckversuch zu Abrissen führte. Es konnte keine Folie hergestellt werden.

**Vergleichsbeispiel 2**

Es wurde eine ABC-Folie mit den gleichen Dimensionen wie in Beispiel 1 hergestellt.
Rohstoffmischung Deckschicht A: 50 Gew.-% MB1; 10 Gew.-% MB2; 10 Gew.-% MB5; 30 Gew.-% R1
Rohstoffmischung Basisschicht B: 100 Gew.-% R1
Rohstoffmischung Deckschicht C: 20 Gew.-% MB2; 80 Gew.-% R1

**Vergleichsbeispiel 3**

Beispiel 1 wurde wiederholt. Die Thermofixierung erfolgte jedoch nicht, wie oben angegeben, bei 229 °C, sondern bei 150 °C und es erfolgte keine Relaxation.
Die Eigenschaften der Folien aus den Beispielen 1 bis 4 und den Vergleichsbeispielen 2 und 3 können der Tabelle entnommen werden.

**Leiterbahnerzeugung**

Die hergestellten Folien wurden im Bereich der aufzubringenden Leiterbahnen mit einem Laser (frequenz-

verdreifachten Nd:YAG-Laser ($\lambda$ = 355 nm) der Fa. LPKF AG/DE, mit einer Intensität bestrahlt, die einen geringfügigen Abtrag erzeugt, der mit einer strukturierten Bekeimung verbunden ist. Nach kurzer Behandlung in einem, demineralisiertes Wasser enthaltenden Ultraschall-Reinigungsbad wird die Folie durch ein handelsübliches chemisch reduktives Verkupferungsbad geführt. Hierdurch wurden in den bestrahlten Bereichen die Leiterbahnen aufgebaut. Abtrag 0,5 bis 1,0 $\mu$m.

**Ergebnisse der Leiterbahnerzeugung**

Die erzeugten Leiterbahnen wurden mittels eines Lichtmikroskops (Auflicht) bei 20-facher Vergrößerung visuell beurteilt. Die Geschlossenheit der Kupferschicht wurde visuell bewertet und in die folgenden Kategorien eingeteilt: gut, weniger gut und schlecht.

Zur Beurteilung der Haftung des abgeschiedenen Metalls auf der Folie wurde, wie oben beschrieben, eine Leiterbahn (Länge: 2,5 cm; Breite: 3 mm) durch Aktivierung und nachfolgende Verkupferung hergestellt. Anschließend wurde quer über die Leiterbahn ein Klebestreifen (Scotch® Tape 600 von 3M/US) geklebt. Der Klebestreifen wurde in einem Winkel von 90° zur Folienoberfläche mit einer konstanten Geschwindigkeit von 0,2 cm/s abgezogen. Der Klebestreifen wurde unter dem Lichtmikroskop (Auflicht) bei 20-facher Vergrößerung betrachtet. Falls kein abgelöstes Kupfer auf der Klebefläche sichtbar war, wurde die Haftung des Kupfers auf der Folie mit ausreichend (+) bewertet, anderenfalls war die Haftung nicht ausreichend (-).

Tabelle

| Beispiel | E-Modul MD in N/mm$^2$ | E-Modul TD in N/mm$^2$ | Schrumpf MD 200 °C | Schrumpf TD 200 °C | Leiterbahnerzeugung | Metallhaftung |
|---|---|---|---|---|---|---|
| 1 | 4200 | 5200 | 4,8 | 1,8 | sehr gut | + |
| 2 | 4300 | 5000 | 4,2 | 1,9 | sehr gut | + |
| 3 | 4200 | 5000 | 4,5 | 1,8 | mittel *) | + |
| 4 | 3850 | 4300 | 3,8 | 1,7 | sehr gut | + |
| Vergleichs beispiel | | | | | | |
| 1 | keine Folie erhalten | keine Folie erhalten | keine Folie erhalten | keine Folie erhalten | keine Folie erhalten | keine Folie erhalten |
| 2 | 4300 | 5200 | 4,2 | 2,1 | sehr gut | - |
| 3 | 4500 | 5600 | 20 | 23 | gut **) | + |

*) Bei gleicher Intensität und Bestrahldauer wie in den Beispielen 1 und 2 war die Leiterbahnqualität deutlich schlechter bis unzureichend. Bei einer Erhöhung der Bestrahldauer konnten jedoch gute Werte erreicht werden.

**) Nach Laserbestrahlung bildeten sich jedoch Falten, die eine Weiterverwendung der Folie unmöglich machen.

**Patentansprüche**

1. Ein- oder mehrschichtige, mindestens uniaxial gestreckte thermoplastische Polymerfolie mit einer Dicke von 5 bis 500 $\mu$m, **dadurch gekennzeichnet, dass** sie 0,5 bis 15 Gew.-%, jeweils bezogen auf die Folie, einer durch elektromagnetische Strahlung aktivierbaren Metallverbindung a) enthält, wobei mindestens eine Schicht aus einem thermoplastischen Polymer mit einer Mindestmenge an Amidgruppen besteht.

2. Folie nach Anspruch 1, **dadurch gekennzeichnet, dass** das thermoplastische Polymer ein Polyester, ein Polyamid oder eine Mischung aus Polyester und Polyamid ist.

3. Folie nach Anspruch 1 oder 2, **dadurch gekennzeichnet, dass** der Polyester ein Polyethylenterephthalat, Polybutylenterephthalat, Polyethylennaphthalat oder eine Mischung daraus ist

4. Folie nach einem oder mehreren der Ansprüche 1 bis 3, **dadurch gekennzeichnet, dass** die Folie zusätzlich ein Strahlung absorbierendes Materials b) und weitere Additive enthält, sowie vorzugsweise 1,5 bis 10 Gew.-% der Komponente a) und vorzugsweise 0,5 bis 5 Gew.-% der Komponente b), jeweils bezogen auf die Folie, enthält.

**5.** Folie nach einem oder mehreren der Ansprüche 1 bis 4, **dadurch gekennzeichnet, dass** die durch Strahlung aktivierbare Metallverbindung a) eine elektrisch nichtleitende, thermisch hochstabile organische oder anorganische Verbindung, vorzugsweise ein Metalloxid oder ein Spinell ist.

**6.** Folie nach Anspruch 4, **dadurch gekennzeichnet, dass** das Strahlung absorbierende Material b) Graphit, Ruß oder anorganisches und organisches Schwarzpigment ist.

**7.** Folie nach einem oder mehreren der Ansprüche 1 bis 6, **dadurch gekennzeichnet, dass** sie weitere partikuläre Additive enthält.

**8.** Folie nach Anspruch 7, **dadurch gekennzeichnet, dass** sie Siliciumdioxid oder $Al_2O_3$ enthält.

**9.** Folie nach Anspruch 7 oder 8, **dadurch gekennzeichnet, dass** sie 0,1 bis 20 Gew.-% Siliciumdioxid- oder $Al_2O_3$ - Partikel mit einem $d_{50}$-Wert von $\leq$ 1 µm enthält.

**10.** Folie nach einem oder mehreren der Ansprüche 1 bis 9, **dadurch gekennzeichnet, dass** sie mindestens zweischichtig ist und aus einer Basisschicht und mindestens einer Deckschicht besteht.

**11.** Folie nach Anspruch 10, **dadurch gekennzeichnet, dass** sie einen dreischichtigen Aufbau A-B-A oder A-B-C besitzt.

**12.** Folie nach Anspruch 10 oder 11, **dadurch gekennzeichnet, dass** die Dicke der Deckschichten im Bereich von 0,1 bis 10 µm liegt und sich die Dicke der Basisschicht aus der Differenz von Gesamtdicke der Folie und der Dicke der aufgebrachten Deck- und Zwischenschicht(en) ergibt.

**13.** Folie nach einem oder mehreren der Ansprüche 1 bis 12, **dadurch gekennzeichnet, dass** sie einen E-Modul in mindestens einer Folienrichtung (Längsrichtung (MD) und/oder Querrichtung (TD)) von $\geq$ 500 $N/mm^2$ aufweist.

**14.** Folie nach einem oder mehreren der Ansprüche 1 bis 13, **dadurch gekennzeichnet, dass** sie Rezyklat als Rohstoff enthält.

**15.** Verfahren zur Herstellung einer ein- oder mehrschichtigen, mindestens uniaxial gestreckten thermoplastischen Polymer-Folie nach Anspruch 1 mit einer Dicke von 5 bis 500 µm, **dadurch gekennzeichnet, dass** man die den einzelnen Schichten der Folie entsprechenden Schmelzen, von denen mindestens eine aus einem thermoplastischen Polymer mit einer Mindestmenge an Amidgruppen besteht und eine durch elektromagnetische Strahlung aktivierbare Metallverbindung a) enthält, zusammen durch eine Schlitzdüse extrudiert, die erhaltene Folie abkühlt, erneut erhitzt und anschließend mindestens in einer Richtung orientiert und dann thermofixiert.

**16.** Verfahren nach Anspruch 15, **dadurch gekennzeichnet, dass** mindestens eine der Schmelzen jeweils zusätzlich ein Strahlung absorbierendes Material b) und weitere partikuläre Additive enthält.

**17.** Verfahren nach Anspruch 15 und 16, **dadurch gekennzeichnet, dass** die Komponenten a) in einer Menge von 0,5 bis 15 Gew.-% und b) in einer Menge von 0,1 bis 15 Gew.-%, jeweils bezogen auf die Folie, zugesetzt werden und dass die Zugabe über die Masterbatchtechnologie erfolgt.

**18.** Verwendung der Folie nach einem oder mehreren der Ansprüche 1 bis 14 in Leiterplatten, Flachbandkabel, Smartcards, RFID-Labels, Folientastaturen und folienbasierten Schaltungen.

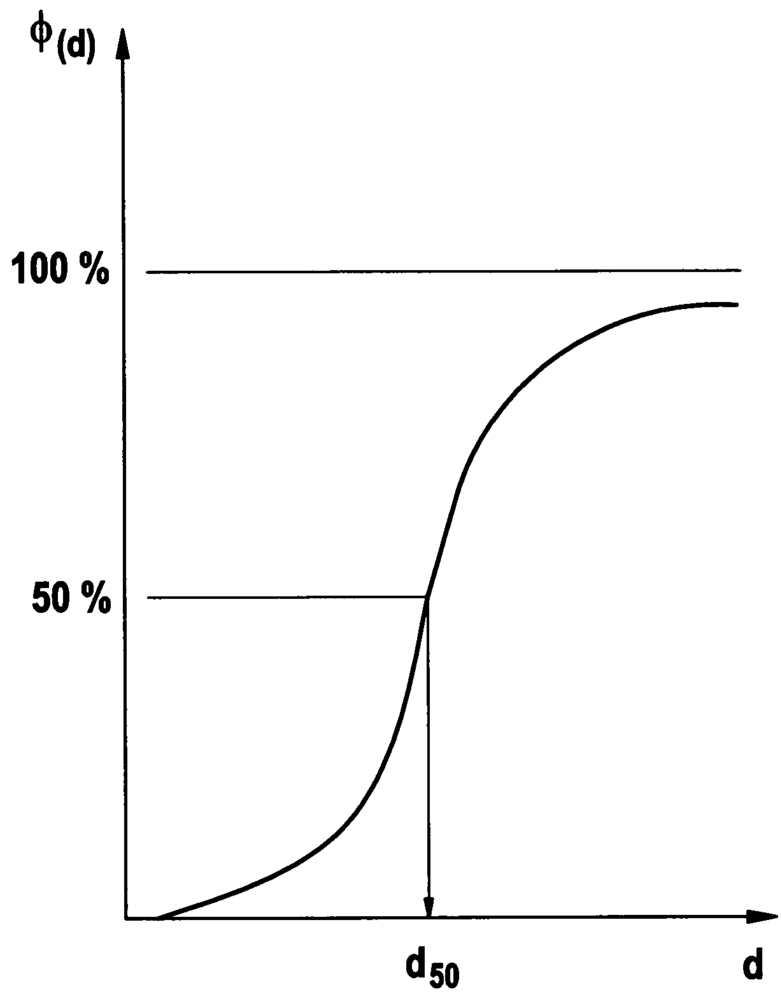

$\phi_{(d)}$
100 %
50 %
$d_{50}$
d